# EUROPEAN PATENT SPECIFICATION

(11) **EP 0 607 251 B1**
(45) Date of publication and mention of the grant of the patent: **27.12.2000**
(21) Application number: 92921271.0
(22) Date of filing: 07.10.1992
(51) Int. Cl.: H01L 31/0232, H01L 31/052, G02B 17/06

(54) **IMPROVED OPTICAL DESIGN FOR PHOTO-CELL**
VERBESSERTES OPTISCHES DESIGN FÜR PHOTOZELLE.
AMELIORATIONS APPORTEES A LA CONCEPTION DE L'OPTIQUE DES PHOTOCELLULES

(30) Priority: 08.10.1991 AU 878791
(43) Date of publication of application: 27.07.1994
(73) Proprietor: UNISEARCH LIMITED, Kensington New South Wales, 2033 (AU)
(72) Inventor: WENHAM, Stewart, Ross, Illawong, NSW 2234 (AU); GREEN, Martin, Andrew, Waverley, NSW 2024 (AU)
(74) Representative: Mounteney, Simon James
(86) International application number: AU9200536
(87) International publication number: WO9307646

(56) References cited:
- EP-A- 0 400 367
- WO-A-89/06051
- AU-A- 2 093 688
- DE-A- 3 718 844
- FR-A- 2 400 261
- CONFERENCE RECORD OT THE 21ST IEEE PHOTOVOLTAIC SPECIALISTS CONFERENCE 1990, vol.1, 21 May 1990, KISSIMIMEE, US pages 251 - 256 CULIK ET AL. 'DEEPLY-GROOVED SILICON CONCENTRATOR SOLAR CELLS FOR USE WITH PRISMATIC COVERS'
- SOLAR ENERGY, vol.21, 1978, OXFORD GB MILLS ET AL. 'IDEAL PRISM SOLAR CONCENTRATORS'
- IBM TECHNICAL DISCLOSURE BULLETIN., vol.13, no.3, August 1970, NEW YORK US pages 591 - 592 RICHARDS 'PHOTOTDETECTOR AS FUNCTION DETECTOR'
- PATENT ABSTRACTS OF JAPAN vol. 12, no. 150 (E-606) 10 May 1988 & JP-A-62 266 879 (AGENCY OF IND SCIENCE & TECHNOL) 19 November 1987

## Description

### TECHNICAL FIELD

This invention relates to a device for receiving and for directing light in a three dimensional manner to at least one predetermined location and a combination of the device and a photo-device having a light absorbing surface.

### BACKGROUND ART

Light trapping within silicon substrates for solar cells has received considerable attention in recent years. The highest efficiency silicon solar cell reported by Wang et alia, Appl. Phys. Lett. 57 (6), p. 602, has been measured to have an efficiency of 24.2% under standard test conditions. Such high performance silicon cells make extensive use of geometrical structures chosen to cause light to be multiply totally internally reflected giving substantial increases for the pathlength the light traverses before escaping from the silicon. Due to the large difference between the refractive index of silicon and that of air, such light trapping schemes can be designed relatively simply while being quite effective. For a transparent medium such as glass, however, where the refractive index is only about 1.5 or less, it is relatively more difficult to totally internally reflect virtually all light within the transparent medium that strikes the air interface. This is because the escape angle for glass and similar refractive index media is approximately 45°, with the consequence that all light within the glass that strikes the glass/air interface within 45° to the normal will escape to the air.

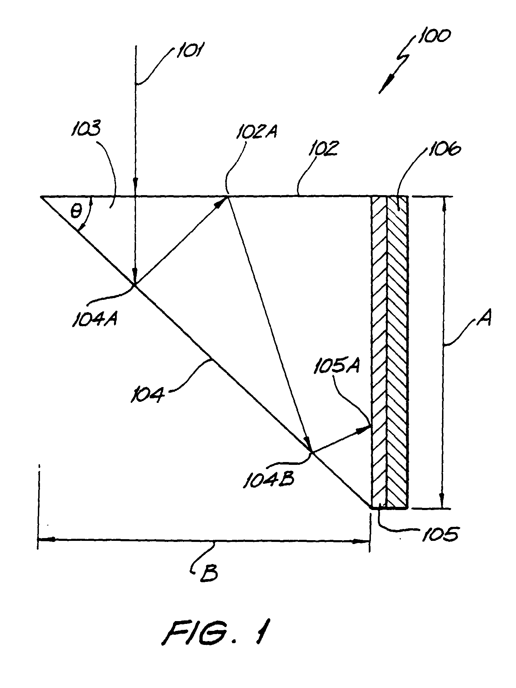

In the area of concentrator solar cells, various schemes and designs for the optics have been proposed for the purpose of steering the light onto the solar cell surface. One such scheme is that proposed by Mills and Giutronich, Solar Energy 21 (1978), pp. 423-430, where the front and rear surfaces of a glass or equivalent structure are at an appropriate angle to each other to ensure that light reflected from the rear surface strikes the glass/air interface at the top surface outside the escape angle and is therefore totally internally reflected. In this scheme, a solar cell is mounted perpendicular to the top surface and at the end of the wedge-shaped structure so as to receive the light that has been trapped within the structure. This scheme is shown in Fig. 1 which is a schematic cross section side view of a device 100 for directing light in two dimensions. In Fig. 1 a beam of incoming light 101 passes through top surface 102 of triangular glass structure 103 to point 104A, is reflected at point 104A by reflector 104 to point 102A, totally internally reflected at point 102A by surface 102 to point 104B and is reflected at point 104B by reflector 104 to point 105A where it is absorbed by top surface 105 of solar cell 106. One severe limitation of this scheme for many applications is the large value of θ required to ensure light reflected from reflector 104 is totally internally reflected when subsequently striking the glass/air interface at surface 102. This large value of θ results in dimension A having to be relatively large in comparison to dimension B unless the acceptance angle for incoming light 101 is greatly reduced. Furthermore, in this scheme, no light falls directly onto cell 106, only reflected light.

W0-A-92/11557, which belongs to the state of the art according to Article 54(3), discloses a structure which includes reflecting elements arranged in at least three different planes. However, this structure does not use the mechanism of total internal reflection.

### OBJECTS OF INVENTION

Objects of this invention are to provide a device for receiving and for directing light in a three dimensional manner to at least one predetermined location and a combination of the device and a photo-device having a light absorbing surface.

### DISCLOSURE OF INVENTION

According to a first embodiment of this invention there is provided a device for receiving and for directing light to at least one predetermined location, the device having at least one receiver/director for directing light to a predetermined location,
the receiver/director comprising:
a total internal reflection surface capable of transmitting incoming light externally incident on said totally internally reflecting surface into the device and of totally internally reflecting the light incident on the total internal reflection surface at an angle in at least one plane which is within the range for total internal reflection; and
light reflecting surfaces (504, 505), the reflecting surfaces and the total internal reflection surface being operatively disposed with respect to one another to reflect and direct incoming light transmitted by the total internal reflection surface into the device, in a three dimensional manner to the predetermined location, characterised in that the receiver/director includes at least two grooves, each groove having two reflector surface which are mutually disposed to form the groove, each groove (804) being filled-in with a light-transparent material, the grooves being disposed relative to the total-reflection surface such that the base line of each groove defined by the intersection of reflector surfaces (504, 505) is inclined relative to the total-internal-reflection surface.

According to a second embodiment of this invention there is provided a combination comprising at least one device of the first embodiment together with at least one photo-device having a light absorbing surface, at least part of the light absorbing surface being operatively disposed at the predetermined location to absorb light reflected and directed by the receiver/director.

According to another embodiment of the present invention, there is provided a device (500) for receiving and for directing light to at least one predetermined location, the device having at least one receiver/director for directing light to a predetermined location (513),
the receiver/director comprising:
a surface (503) capable of transmitting incoming light (501) externally incident on said surface (503) into the device; and
light reflecting surfaces (504, 505), the reflecting surfaces (504, 505) and the surface (503) being operatively disposed with respect to one another to form a hollow groove (804), characterised in that the receiver/director includes at least two hollow grooves (804), each groove (804) capable of being filled with a light transparent material to form an optical cavity, the grooves (804) being disposed relative to surface (503) such that the base line of each groove (804) defined by the intersection of reflector surfaces (504) and (505) is inclined relative to the surface (503), and wherein said surface (503) is capable of totally internally reflecting the light incident on said surface (503) at an angle in at least one plane which is within the range for total internal reflection when said groove (804) is filled with said light transparent material, said reflecting surfaces (504, 505) and said surface (503) further being operatively disposed with respect to one another and the predetermined location (513) to direct incoming light (501) transmitted by the surface (503) into the device, in a three dimensional manner to the predetermined location (513).

Generally, the receiver/director may comprise filled-in symmetric or asymmetric tilted grooves. The filled-in portion of the grooves comprises light transparent material. The reflecting surfaces may be covered with light reflecting material or may be totally internally reflecting surfaces. Alternatively, the grooves could be hollow symmetric or asymmetric tilted grooves covered with the total internal reflection surface. The hollow portion of the latter groove could contain light transparent fluids including liquids.

Generally, the device has a plurality of receiver/directors, typically 2 - 1000, more typically 2 - 100 and even more typically 4 - 20. Alternatively, the device may also have one receiver/director. In the case where the device has one receiver/director the device may be the receiver/director. Alternatively, the device may be a structural component such as a brick, tile or may be part of a panel, and as indicated above the device may include 1 receiver/director or may include a plurality of receiver/directors.

Typically, the light absorbing surface is the underside of a photo-device.

Generally, the combination of the second embodiment comprises a plurality of devices of the first embodiment, typically 2 - 10,000, and a plurality of photo-devices, typically 2 - 10,000. Alternatively, the combination of the second embodiment may have one device which may have one receiver/director or a plurality of receiver/directors together with one photo-device or together with a plurality of photo-devices. As a further alternative, the combination of the second embodiment may have a plurality of devices each of which may have one receiver/director or a plurality of receiver/directors together with one photo-device. In the case where the device has one receiver/director the device may be the receiver/director. Typically, the combination of the second embodiment is in the form of a panel (including a roof panels and wall panels), a tile or a brick. Alternatively, the combination of the second embodiment may be in the form of panels for motor vehicles such as roof panels, boot panels, door panels, bonnet panels and other car panels.

Generally, in the combination of the second embodiment the device of the first embodiment further includes a reflector or an extension of one of the two reflecting light surfaces operatively disposed in relation to the total internal reflection surface and the light absorbing surface and/or the two light reflecting surfaces to directly reflect incident light from the total internal reflection surface and/or two light reflecting surfaces to the light absorbing surface.

Typically, the photo-device is a light converting cell, more advantageously a solar cell such as a p-n photo cell, an amorphous photo cell, a Schottky photo cell, a photoelectrochemical photo cell an MIS photo cell an n-n photo cell or a p-p photo cell. The photo cells may be for converting solar light, light from light sources such as tungsten and fluorescent tubes, photodiodes or lasers into electricity. Typically, the photo cell is a solar cell. Semiconductor substrate materials such as silicon, germanium, CdTe, CuInSe2, GaAs, AlGaAs, GaP, GaAsP, SiC, InP and other photovoltaically active semiconductors are particularly suitable for p-n photovoltaic cells and particularly for p-n photovoltaic solar cells. The semiconductor substrate material can be thin films, single crystal or polycrystalline material. It may be continuous or discontinuous. Thin films may be supported on a transparent substrate or superstrate such as glass, quartz, perspex or other suitable superstrate. When the superstrate is transparent to the illuminating light the array can be illuminated through the superstrate. The semiconductor substrate material may be used with appropriate antireflection coatings and fabricated using appropriate antireflection geometries. To make use of light being steered into the rear of a photo cell or solar cell while other light is coupled into the top surface, a bifacial cell design is clearly necessary. A number of different solar cell technologies have developed and demonstrated bifacial solar cell designs. To make most effective use, however, of the proposed invention, the solar cell design is generally optimized and fabricated for operation at light intensity levels well above those normally experienced in conventional photovoltaic modules. To extract power from a solar cell, at least two connections of different potential must be made to the solar cell. To extract current, conductors are necessary to allow a current to flow to either an adjacent solar cell or out of the encapsulation. One effective way to conduct current from one location within the encapsulation to another, is to make use of a conductive rear reflector that is appropriately patterned and connected to the relevant solar cells.

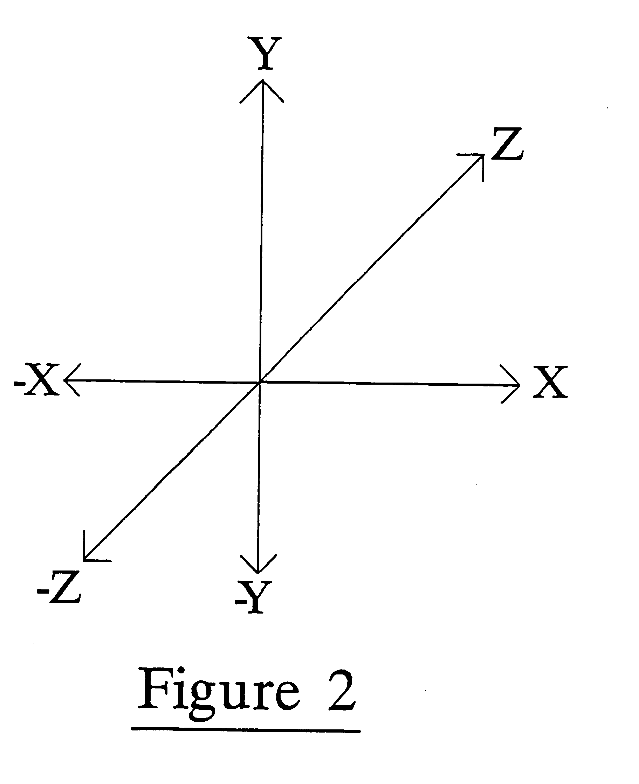

The X, Y, Z directions for the purposes of this description are defined in Fig. 2 where the labelled axes are orthogonal to each other. The device of the present invention makes use of the third dimension where reflected light from the reflecting rear surfaces has its component in the Z direction altered by the reflection. The benefit of altering the Z component of the reflected light is that total internal reflection can then be achieved when the light subsequently strikes the top surface glass/air interface without the large values of θ necessary for the scheme of Fig. 1. Typically two reflecting surfaces form a tilted groove with one another and the totally reflecting surface is at the top of the groove whereby the magnitudes of the angles subtended by the reflecting surfaces to the total internal reflection surface in the Z-Y plane are such that normally incident light will restrike the total internal reflection surface at angles of magnitudes such that they are totally internally reflected at the total internal reflection surface and are simultaneously directed to one end of the tilted groove in the X-direction. The tilted groove may be symmetric or asymmetric. The magnitudes of the angles subtended by the reflecting surfaces to the total internal reflection surface in the X-Y plane do not play an important role with regard to causing total internal reflections at the total internal reflection surface until light has been reflected to the total internal reflection surface more than once. When this condition is reached, the multiple reflections will have already caused a sufficient component for the light in the X direction to have been established that will then cause total internal reflection at the total internal reflection surface for all subsequent occasions independent of the component for the light in the Z direction. Appropriate selection for the magnitudes of the angles subtended by the reflecting surfaces to the total internal reflection surface in the Z-Y plane and the magnitudes of the angles subtended by the reflecting surfaces to the total internal reflection surface in the X-Y plane will lead to the majority of incident light for all significant angles of incidence to be reflected and directed within the receiver/director. The other important feature of the angles subtended by the reflecting surfaces to the total internal reflection surface in the Z-Y plane is that they cause incident light to accumulate an increased component of travel in the X direction for each reflection from each of the reflecting surfaces. This acts to steer the light in the X direction to a predetermined location where a photovoltaically active cell, for example, may be located.

The receiver/director may be formed from a transparent medium in shape of a tilted groove, the transparent material being selected from a range of glasses, acrylics, epoxies, plastics, polymers or pottant materials, for example. For a glass structure, moulding or perhaps rolling could be used. Another approach would be to use a plastic or equivalent moulding or machine or fabricate an appropriate material to form the tilted grooves, coating the top surfaces of the moulding, machined or fabricated grooves to make the top surfaces reflective and filling the grooves with a transparent material such as EVA to fill and form the optical cavities and the total internal reflection surface.

The devices of the invention steer laterally to photo cells, typically, solar cells, incident light that would not otherwise illuminate the cells. The structures make use of total internal reflection to prevent light from escaping the same surfaces through which the incoming light passed. In one particular embodiment of the invention, a photovoltaic module can incorporate these structures to allow a reduced packing factor for the photovoltaic cells while still allowing virtually all incident light onto the module to be transferred to the solar cells. In this application, light incident on non-cell areas is steered laterally through the use of total internal reflection at the air interface into photovoltaically active regions where the cells are located. The resulting reduced packing factors (typically 20-50%) facilitate substantial reduction for the cost per unit of electricity generated since the photovoltaic cell cost in conventional photovoltaic module design substantially dominates the total encapsulation costs.

### BRIEF DESCRIPTION OF DRAWINGS

The preferred embodiments of the invention are now described with reference to the following drawings in which:
Fig. 1 is a schematic cross section side view of a device for directing light in two dimensions;
Fig. 2 depicts orthogonal axes X, Y and Z;
Fig. 3 schematically depicts a cross-section, in the Y-Z plane, of a solid, transparent tilted groove of the invention;
Fig. 4 schematically depicts a cross-section, in the X-Y plane, of a solid, transparent tilted groove of the invention;
Fig. 5 schematically depicts a cross-section, in the X-Y plane, of a solid, transparent tilted groove of the invention operatively disposed in relation to an adjacent solar cell and a reflector under the solar cell to direct light to the reflector which in turn reflects light to the underside of the solar cell;
Fig. 6 schematically depicts a plan view of 5 solid, transparent tilted grooves of the invention operatively disposed to receive and direct light into the underside of an adjacent solar cell;
Fig. 7 schematically depicts a plan view of a panel comprising a checkerboard layout of a plurality of devices for receiving and for directing light in a three dimensional manner into the undersides of adjacent solar cells;
Fig. 8 schematically depicts a cross-section, in the X-Y plane, of a plastic moulding, which with a reflective top surface, may form the reflective rear surface of a solid, transparent tilted groove of Fig. 5;
Fig. 9 schematically depicts a cross-section, in the X-Y plane, of a solid, transparent tilted groove of the invention, where the transparent medium is formed by the use of ethyl vinyl acetate or other appropriate transparent material in conjunction with a plastic moulding with a reflective top surface of Fig.8;
Fig. 10 schematically depicts a photovoltaic roof tile; and
Fig. 11 schematically depicts a cross-section of one of the grooves of the photovoltaic roof tile of Fig. 10 in the YZ plane.

### BEST MODE AND OTHER MODES FOR CARRYING OUT INVENTION

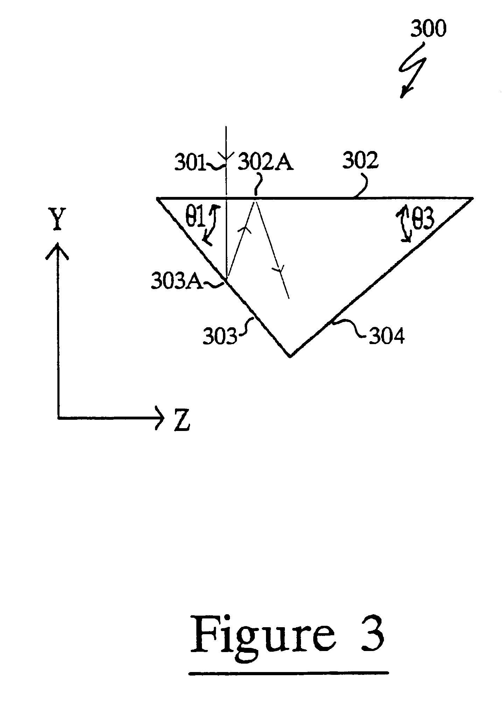

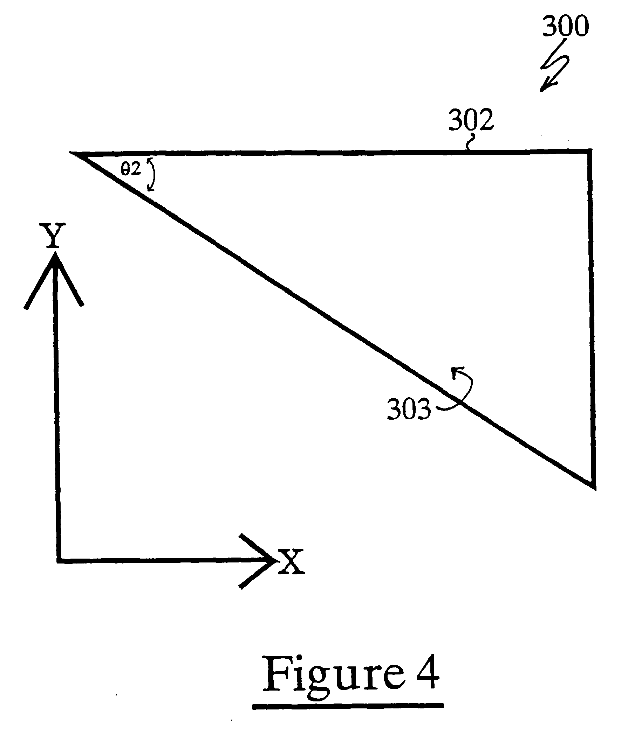

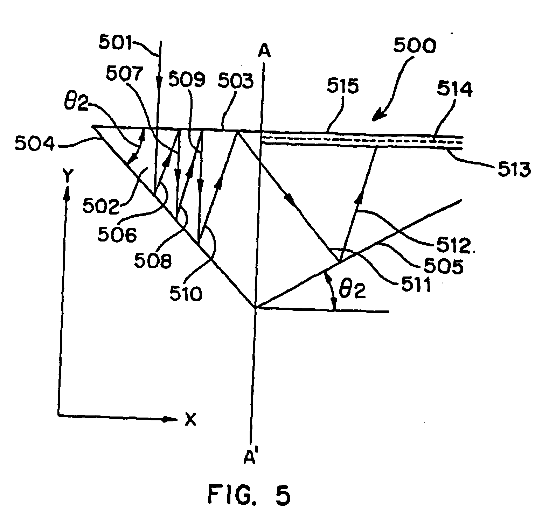

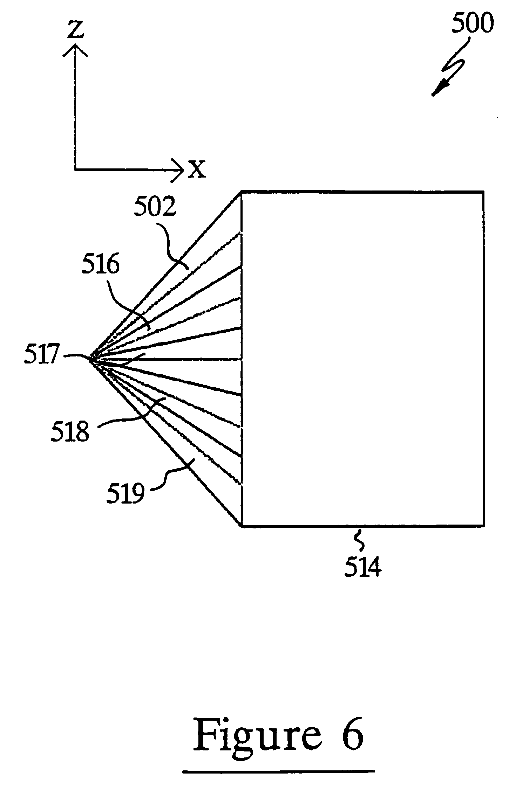

The scheme of Fig. 1 is basically two-dimensional with no attempt to alter the light's component of travel in the Z direction (third dimension). The X, Y, Z directions for the purposes of this description are defined in Fig. 2 where the labelled axes are orthogonal to each other. The present invention makes use of the third dimension where reflected light from a reflector surface located at the rear of a device has its component in the Z direction altered by the reflection. The benefit of altering the Z component of the reflected light is that total internal reflection can then be achieved when the light subsequently strikes top surface glass/air interface at the top of the device without the large values of θ necessary for the scheme of Fig. 1. A scheme that has demonstrated very effective light trapping and steering capabilities is that of tilted grooves. A cross-section of a glass tilted groove 300 in the Z-Y plane is shown in Fig. 3. Tilted groove 300 has glass/air interface 302 and rear reflecting surfaces 303 and 304. If the angle θ1 is greater than 22.5°, then normally incident light 301 as shown in Fig. 3 will restrike glass/air interface 302 at an angle of greater than 45° to the normal after a single reflection from rear reflecting surface 303 at point 303A and hence be totally internally reflected at top surface glass/air interface 302 as shown at point 302A. This total internal reflection will occur irrespective of the tilt angle of the rear surface in the X direction as given by the angle θ in Fig. 1. The equivalent angle θ2 in the X direction for the present scheme is shown in Fig. 4 which represents a cross-section of the tilted groove 300 in the X-Y plane. This angle, θ2, does not play an important role with regard to causing total internal reflections at top surface glass/air interface 302 until light has been reflected to this top surface glass/air interface 302 more than once. When this condition is reached, the multiple reflections will have already caused a sufficient component for the light in the X direction to have been established that will then cause total internal reflection at the top surface glass/air interface 302 for all subsequent occasions independent of the component for the light in the Z direction. Appropriate selection for the angles θ1 and θ2 will allow the majority of incident light for all significant angles of incidence to be trapped within the transparent medium as indicated by the cross-sections in Fig. 3 and Fig. 4. The other important feature of the angle θ2 is that it causes incident light 301 to accumulate an increased component of travel in the X direction for each reflection from rear reflecting surfaces 303 and 304. This acts to steer the light in the X direction to a predetermined location where a photovoltaically active cell is located. One implementation of the present invention is combination 500 shown in Fig. 5 which is a cross-section in the X-Y plane where again the planes are defined by Fig. 2. In Fig. 5, incident light 501 on device 502 is shown to be steered laterally by internal reflection surface 503 and reflecting surfaces 504 and 505 via paths 506, 507, 508, 509, 510, 511 and 512 in the X direction and into rear 513 of solar cell 514. Solar cell 514 could have been located in place of reflecting surface 505 to allow all light to enter front surface 515 of solar cell 514. One benefit of the configuration of Fig. 5, however, is that the location of solar cell 514 as shown aids the dissipation of heat from solar cell 514. The photovoltaic solar cell 514 could in fact be located anywhere from the top surface adjacent surface 503 as shown in Figure 5 to rear surface 505 (which could be horizontal for the case θ2' = 0) depending on thermal considerations and the desired balance between how much, light enters front 515 of cell 514 relative to that entering rear 513 of cell 514. Ease of manufacture and cell interconnection etc. may also influence this preferred position. The geometry of reflecting surface 505 located directly beneath solar cell 514 is selected to optimize the directing of light up to rear surface 513 of solar cell 514. Its actual geometry could be simply the mirror image of rear surface 505 reflected in the AA' plane as shown in Fig. 5 with θ2 = θ2', although for some cell sizes and shapes, it is preferable to use a rear reflector slope (θ2') that progressively increases with distance in the X direction from the AA' plane (edge of solar cell 514) in line with the centre of solar cell 514. In general, the preferred geometry and angle for θ2' as a function of distance in the X direction are determined by solar cell 514 shape, size and its electrical and optical characteristics for example, the distribution of light intensity across cell surface 513 will be determined primarily by the shape of surface 505, with large variations in light intensity able to be tolerated without significant loss in performance by only some solar cell technologies such as the buried contact solar cell. Fig. 6 shows a view of combination 500 looking downwards in the minus Y direction at the top surfaces of the combination which occurs in the X-Z plane. Combination 500 only shows five tilted grooves 502, 516, 517, 518 and 519 located on one side of solar cell 514, but could clearly be located equivalently on all other sides. This implementation of tilted grooves 502, 516, 517, 518 and 519 makes use of five tilted grooves for a side of solar cell 514 although the number of grooves can be significantly varied from one up to virtually any number. In conjunction with the number of grooves, the angles θ1 (see for example Fig. 3), θ2 (see for example Fig. 5) and θ3 (see for example Fig. 3), can be selected to optimize performance. The actual values for θ1, θ2 and θ3 could potentially lie within a large range of angles, bounded at one extreme by the case where most reflected light at surface 503 is no longer totally internally reflected and at the other extreme where device 502 dimensions are no longer practical (particularly the thickness) for fabrication and use.

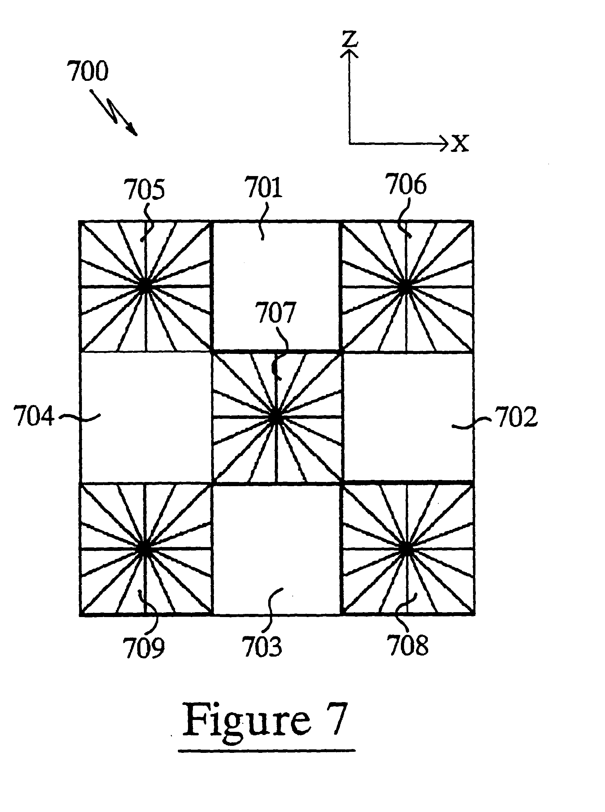

Fig. 7 shows a plurality of combinations of the type shown in Figs. 5 and 6 incorporated in panel subsection 700. In Fig. 7 panel subsection 700 has a plurality of solar cells 701, 702, 703 and 704 configured in a checkerboard pattern with all non-cell areas 705, 706, 707, 708 and 709 utilizing tilted grooves of the type shown in Figs. 5 and 6 to steer the majority of light incident on these regions to photovoltaically-active regions where solar cells 701, 702, 703 and 704 are located.

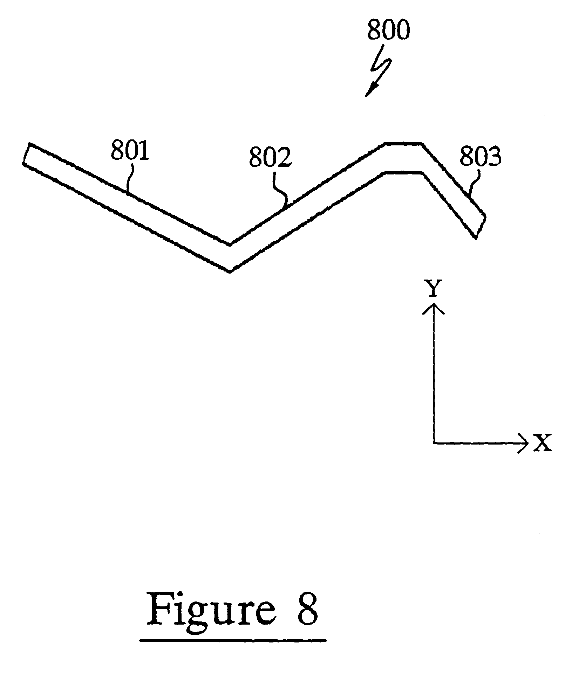

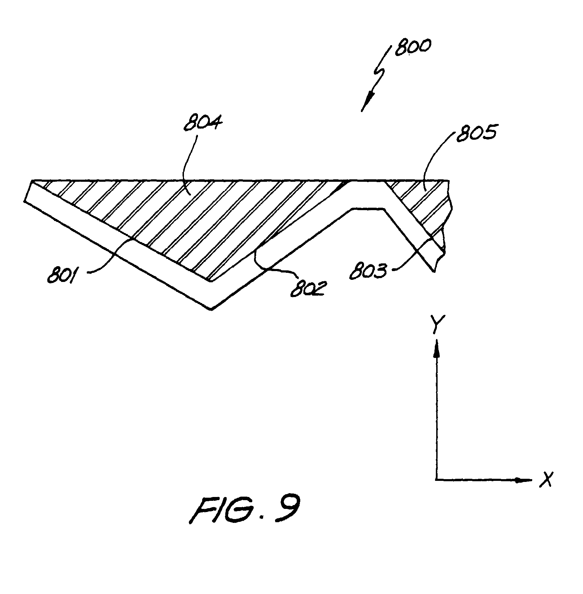

The transparent medium in device 502 could be formed from a range of glasses, acrylics, plastics, polymers or pottant materials, etc. For a glass structure, moulding or perhaps rolling could be used. Another approach would be to use a plastic or equivalent moulding 800 with a typical shape as shown in Fig. 8 to provide the same effect of the rear surface as shown in Fig. 5. In this instance, top surfaces 801, 802 and 803 of plastic moulding 800 would be coated to make surfaces 801, 802 and 803 reflective, hence making each of them equivalent to reflecting surfaces 504 and 505 of Fig. 5. Optical cavities 804 and 805 would then be formed as shown in Fig. 9 where the shaded area shows the use of a transparent material such as EVA to fill and form optical cavities 804 and 805.

To make use of light being steered into rear surface 513 of solar cell 514 while other light is coupled into top surface 515, a bifacial cell design is clearly necessary. A number of different solar cell technologies have developed and demonstrated bifacial solar cell designs. To make most effective use, however, of the proposed invention, the solar cell design needs to be optimized and fabricated for operation at light intensity levels well above those normally experienced in conventional photovoltaic modules.

To extract power from a solar cell, at least two connections of different potential must be made to the solar cell. To extract current, conductors are necessary to allow a current to flow to either an adjacent solar cell or out of the encapsulation. One effective way to conduct current from one location within the encapsulation to another, is to make use of a conductive rear reflector that is appropriately patterned and connected to the relevant solar cells.

A photovoltaic panel formed from the configuration of Fig. 7 will have a solar cell packing factor of approximately 50%. This packing factor can be reduced to lower values although the performance of the transparent regions and rear reflecting surfaces in steering the light laterally to adjacent solar cells will often be slightly reduced. By replacing the square solar cells 701, 702, 703 and 704 of Fig. 7 with round solar cells that use a diameter equal to the side dimension of the square solar cells 701, 702, 703 and 704 , the packing factor is reduced to approximately 39%. To prevent significant losses from the tilted grooves directing light to where the corners of the square solar cells 701, 702, 703 and 704 had previously been, the grooved geometry for these particular grooves can be modified in the vicinity of each solar cell. Alternatively, the number of grooves being used in Fig. 7 can be beneficially reduced with even a single groove acting to quite effectively couple the light into the adjacent solar cell. As the solar cell dimensions are increased or decreased, the groove lengths must also be reduced or increased correspondingly so that they always terminate in the vicinity of the cell edges. Another important angle other than θ1 and θ2 of Figs. 3 and 4 respectively is θ3 of Fig. 3 which can be varied relative to θ1 to provide asymmetry for tilted groove 300 in the Y-Z plane. Such asymmetry adds an additional valuable component of flexibility with regard to optimizing the structures for multiply totally internally reflecting light that strikes the glass/air interface 302. It can also facilitate optimization for conditions such as when light predominantly enters tilted groove 300 within a range of angles due to the way tilted groove 300 has been mounted. It is also possible by varying θ2 and θ3 appropriately to form a tilted groove 300 in which a significant amount of light can be totally internally reflected from all glass/air interfaces even without the use of a rear reflector on reflecting surface 303. This may be of particular benefit in some applications.

The schemes described so far based on the concept of tilted grooves for light trapping and steering have related primarily to photovoltaic module design and construction. Many other applications, however, exist in which solar cells are encapsulated in a way that can take advantage of this invention. Another example would be for roof tiles where one or more solar cells could be incorporated into a roof tile with each cell being surrounded by tilted grooves to transfer light incident on adjacent regions into the solar cells. One advantage of this application is that the roof tile structures could afford in general to be somewhat thicker and bulkier than a conventional photovoltaic module therefore giving greater flexibility to the selection of the angles θ2 and θ3 to optimize the light capture and transfer and to enable light to be collected for larger distances away from the solar cell edges. A third application would be in solar cars where regions of the car surface exist where it is not practical or legal to incorporate solar cells. These regions could have tilted grooves which act to steer light incident on those areas relatively long distances to solar cells located elsewhere on the car. Again, this is an application where potentially thick structures can be used, therefore enabling light to be transferred laterally by quite large distances. For instance, if the angle θ2 in Fig. 4 is 15°, then a depth in tilted groove 300 of about half a meter would allow light incident on the solar car up to 2 metres away from the cell edge to be coupled and steered across to where the relevant cell is located. In this particular application, it may be advantageous to mount additional solar cells perpendicularly to those near the top surface specifically for the purpose of capturing this laterally-transferred light incident on the non-cell areas. Such cells would in this case be mounted in the Y-Z plane instead of the more usual X-Z plane (which would be the case for all the cells mounted along the top surface of the solar car capturing the light directly).

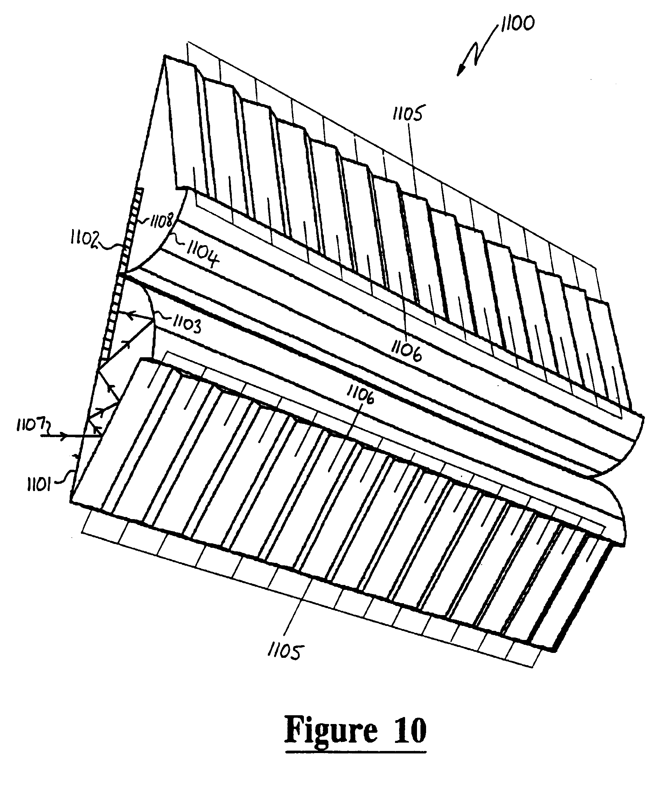

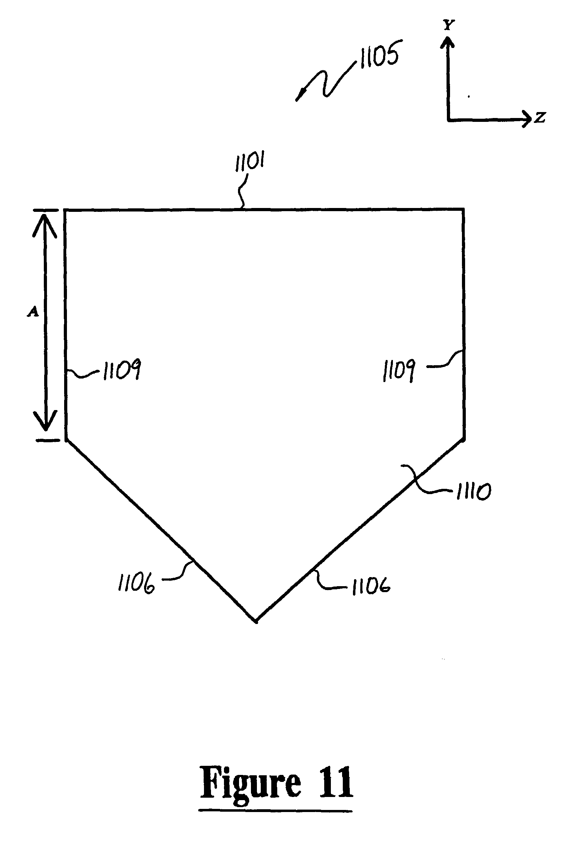

Fig. 7 depicts tilted grooves appearing as triangular formations when viewed from the light source. It is also possible and often desirable for these tilted grooves to appear as rectangles when viewed from above (from the light source) as would be the case in the Example of Fig. 10 which depicts a solar photovoltaic roof tile 1100. Tile 1100 has a light receiving surface 1101, solar photovoltaic cell(s) 1102 located above curved rear surfaces 1103 and 1104, and tilted grooves 1105 having light reflective rear surfaces 1106. Tilted grooves 1105 behave equivalently to the tilted grooves previously discussed with reference to the earlier diagrams. Fig. 11 depicts how an incoming light beam 1107 is steered by tilted groove 1105 and curved rear surface 1103 towards the centre of tile 1100 to the rear surface 1108 of cell 1102(s). Fig. 11 shows the cross-section of one of tilted grooves 1105 in the YZ plane, having light receiving surface 1101, light reflective surfaces 1106 which form the base of groove 1105 and interface borders 1109 which correspond to the interfaces with adjacent grooves. Light receiving surface 1101 is also responsible for total internal reflections of light reflected from surfaces 1106. Groove 1105 is filled with solid transparent medium 1110 and is substantially equivalent to that of Fig. 3 except that the dimension "A" reduces further the distance from the edge of the solar cell.

## Claims

1. A device (500) for receiving and for directing light to at least one predetermined location, the device having at least one receiver/director for directing light to a predetermined location (513),
the receiver/director comprising:
a total internal reflection surface (503) capable of transmitting incoming light (501) externally incident on said totally internally reflecting surface (503) into the device and of totally internally reflecting the light incident on the total internal reflection surface (503) at an angle in at least one plane which is within the range for total internal reflection; and
light reflecting surfaces (504, 505), the reflecting surfaces (504, 505) and the total internal reflection surface (503) being operatively disposed with respect to one another to reflect and direct incoming light (501) transmitted by the total internal reflection surface (503) into the device, in a three dimensional manner to the predetermined location, characterised in that the receiver/director includes at least two grooves (804), each groove (804) having two reflector surfaces (504, 505) which are mutually disposed to form the groove (804), each groove (804) being filled-in with a light-transparent material, the grooves (804) being disposed relative to the total-internal-reflection surface (503) such that the base line of each groove (804) defined by the intersection of reflector surfaces (504, 505) is inclined relative to the total-internal-reflection surface (503).

2. A combination comprising at least one device of claim 1 together with at least one photo-device (514) having a light absorbing surface, at least part of the light absorbing surface being operatively disposed at the predetermined location to absorb light reflected and directed by the receiver/director.

3. The device of claim 1, wherein said at least two grooves (804) are arranged side-by-side.

4. The combination of claim 2, wherein said at least two grooves (804) are arranged side-by-side.

5. The device of claim 1 or claim 3 wherein said at least two grooves (804) are selected from the group consisting of a filled-in symmetric tilted groove, and a filled-in asymmetric tilted groove.

6. The combination of claim 2 or claim 4 wherein said at least two grooves (804) are selected from the group consisting of a filled-in symmetric tilted groove, and a filled-in asymmetric tilted groove.

7. The device of claim 1 wherein the reflecting surfaces are surfaces selected from the group consisting of surfaces covered with light reflecting material and totally internally reflecting surfaces.

8. The combination of claim 2 wherein the reflecting surfaces are surfaces selected from the group consisting of surfaces covered with light reflecting material and totally internally reflecting surfaces.

9. The device of either of claims 3 or 5 wherein the grooves are grooves selected from the group consisting of a symmetric tilted groove filled with light transparent fluid and covered with the total internal reflection surface, an asymmetric tilted groove filled with light transparent fluid and covered with the total internal reflection surface, a symmetric tilted groove filled with light transparent material and covered with the total internal reflection surface, and an asymmetric tilted groove filled with light transparent material and covered with the total internal reflection surface.

10. The combination of either of claims 4 or 6 wherein the grooves are grooves selected from the group consisting of a symmetric tilted groove filled with light transparent fluid and covered with the total internal reflection surface, an asymmetric tilted groove filled with light transparent fluid and covered with the total internal reflection surface, a symmetric tilted groove filled with light transparent material and covered with the total internal reflection surface, and an asymmetric tilted groove filled with light transparent material and covered with the total internal reflection surface.

11. The device of claim 1 comprising a plurality of receiver/directors.

12. The device of claim 11 wherein there are 4- 60 receiver/directors.

13. The combination of claim 2 comprising a plurality of receiver/directors.

14. The combination of claim 13 wherein there are 4 - 60 receiver/directors.

15. The combination of claim 13 comprising a plurality of photo-devices.

16. The device of claim 1 wherein the device is a structural component selected from the group consisting of a brick, a tile or a part of a panel.

17. The combination of claim 2 wherein the device is a structural component selected from the group consisting of a brick, a tile and at least a portion of a panel.

18. The combination of claim 2 wherein the light absorbing surface is the underside of a photo-device.

19. The combination of claim 2 comprising a plurality of receiver/directors and a photo-device.

20. The combination of claim 2 wherein the device further comprises light reflecting surfaces operatively disposed in relation to the total internal reflection surface and the light absorbing surface and, optionally, two light reflecting surfaces to directly reflect incident light from the total internal reflection surface and, optionally, two light reflecting surfaces to the light absorbing surface.

21. The combination of claim 2 wherein the photo-device is a light converting cell.

22. The combination of claim 21 wherein the light converting cell is a cell selected from the group consisting of a p-n photo cell, an amorphous photo cell, a Schottky photo cell, a photoelectrochemical photo cell, an MIS photo cell an n-n photo cell and a p-p photo cell.

23. The combination of claim 22 wherein the light converting cell is a cell selected from the group consisting of a solar cell, a tungsten light converting cell, a halogen light converting cell, a fluorescent light converting cell, a photodiode light converting cell and a laser light converting cell.

24. The combination of claim 23 wherein the cell is a p-n solar cell fabricated from semiconductor material selected from the group consisting of Si, GaAs, AlGaAs, Ge, CdTe, CuInSe₂, GaP, GaAsP and InP.

25. The device of any one of claims 1, 3, 5, 7, 9, 11, 12 or 16, wherein the totally reflecting surface covers the top of the grooves whereby the magnitudes of the angles subtended by the reflecting surfaces to the total internal reflection surface in the Z-Y plane are such that normally incident light will restrike the total internal reflection surface at angles of magnitudes such that they are totally internally reflected at the total internal reflection surface and are simultaneously directed to one end of the tilted groove in the X-direction.

26. The combination of any one of claims 2, 4, 6, 8, 10, 13, 14, 15 or 18 -24 the totally reflecting surface covers the top of the grooves whereby the magnitudes of the angles subtended by the reflecting surfaces to the total internal reflection surface in the Z-Y plane are such that normally incident light will restrike the total internal reflection surface at angles of magnitudes such that they are totally internally reflected at the total internal reflection surface and are simultaneously directed to one end of the tilted groove in the X-direction.

27. A device (500) for receiving and for directing light to at least one predetermined location, the device having at least one receiver/director for directing light to a predetermined location (513),
the receiver/director comprising:
a surface (503) capable of transmitting incoming light (501) externally incident on said surface (503) into the device; and
light reflecting surfaces (504, 505), the reflecting surfaces (504, 505) and the surface (503) being operatively disposed with respect to one another to form a hollow groove (804), characterised in that the receiver/director includes at least two hollow grooves (804), each groove (804) capable of being filled with a light transparent material to form an optical cavity, the grooves (804) being disposed relative to surface (503) such that the base line of each groove (804) defined by the intersection of reflector surfaces (504) and (505) is inclined relative to the surface (503), and wherein said surface (503) is capable of totally internally reflecting the light incident on said surface (503) at an angle in at least one plane which is within the range for total internal reflection when said groove (804) is filled with said light transparent material, said reflecting surfaces (504, 505) and said surface (503) further being operatively disposed with respect to one another and the predetermined location (513) to direct incoming light (501) transmitted by the surface (503) into the device, in a three dimensional manner to the predetermined location (513).

28. A combination comprising at least one device of claim 27 together with at least one photo-device (514) having a light absorbing surface, at least part of the light absorbing surface being operatively disposed at the predetermined location to absorb light reflected and directed by the receiver/director.

29. The device of claim 27, wherein said at least two grooves (804) are arranged side-by-side.

30. The combination of claim 28, wherein said at least two grooves (804) are arranged side-by-side.

31. The device of claim 27 or claim 29 wherein said at least two grooves (804) are selected from the group consisting of a symmetric tilted groove and an asymmetric tilted groove.

32. The combination of claim 28 or claim 30 wherein said at least two grooves (804) are selected from the group consisting of a symmetric tilted groove and an asymmetric tilted groove.

33. The combination of claim 28 wherein the reflecting surfaces are surfaces selected from the group consisting of surfaces covered with light reflecting material and totally internally reflecting surfaces.

34. The device of either of claims 29 or 31 wherein the grooves are grooves selected from the group consisting of a hollow symmetric tilted groove filled with light transparent fluid and covered with the surface (503) and a hollow asymmetric tilted groove filled with light transparent fluid and covered with the surface (503).

35. The combination of either of claims 30 or 32 wherein the grooves are grooves selected from the group consisting of a hollow symmetric tilted groove filled with light transparent fluid and covered with the surface (503) and a hollow asymmetric tilted groove filled with light transparent fluid and covered with the surface (503).

36. The device of claim 27 comprising a plurality of receiver/directors.

37. The device of claim 36 wherein there are 4-60 receiver/directors.

38. The combination of claim 28 comprising a plurality of receiver/directors.

39. The combination of claim 38 wherein there are 4-60 receiver/directors,

40. The combination of claim 38 comprising a plurality of photo-devices.

41. The device of claim 27 wherein the device is a structural component selected from the group consisting of a brick, a tile or a part of a panel.

42. The combination of claim 28 wherein the device is a structural component selected from the group consisting of a brick, a tile and at least a portion of a panel.

43. The combination of claim 28 wherein the light absorbing surface is the underside of a photo-device.

44. The combination of claim 28 comprising a plurality of receiver/directors and a photo-device.

45. The combination of claim 28 wherein the device further comprises light reflecting surfaces operatively disposed in relation to the total internal reflection surface and the light absorbing surface and, optionally, two light reflecting surfaces to directly reflect incident light from the total internal reflection surface and, optionally, two light reflecting surfaces to the light absorbing surface.

46. The combination of claim 28 wherein the photo-device is a light converting cell.

47. The combination of claim 46 wherein the light converting cell is a cell selected from the group consisting of a p-n photo cell, an amorphous photo cell, a Schottky photo cell, a photoelectrochemical photo cell, an MIS photo cell an n-n photo cell and a p-p photo cell.

48. The combination of claim 47 wherein the light converting cell is a cell selected from the group consisting of a solar cell, a tungsten light converting cell, a halogen light converting cell, a fluorescent light converting cell, a photodiode light converting cell and a laser light convening cell.

49. The combination of claim 48 wherein the cell is a p-n solar cell fabricated from semiconductor material selected from the group consisting of Si, GaAs. AlGaAs, Ge, CdTe, CuInSe₂, GaP, GaAsP and InP.

50. The device of any one of claims 7, 27, 29, 31, 34, 36, 37, or 41 wherein the totally reflecting surface is located at the top of the grooves whereby the magnitudes of the angle subtended by the reflecting surfaces to the total internal reflection surface in the Z-Y plane are such that normally incident light will restrike the total internal reflection surface at angles of magnitudes such that they are totally internally reflected at the total internal reflection surface and are simultaneously directed to one end of the tilted groove in the X direction.

51. The combination of any one of claims 28, 30, 32, 33, 35, 38, 39, 40 or 42 to 49 wherein the totally reflecting surface is located at the top of the grooves whereby the magnitudes of the angles subtended by the reflecting surfaces to the total internal reflection surface in the Z-Y plane are such that normally incident light will restrike the total internal reflection surface at angles of magnitudes such that they are totally internally reflected at the total internal reflection surface and are simultaneously directed to one end of the tilted groove in the X-direction.

52. The device of either of claims 3 or 5 wherein the grooves are grooves selected from the group consisting of a symmetric tilted groove filled with light transparent material and covered with the total internal reflection surface, and an asymmetric tilted groove filled with light transparent material and covered with the total internal reflection surface.

53. The combination of either of claims 4 or 6 wherein the grooves are grooves selected from the group consisting of a symmetric tilted groove filled with light transparent material and covered with the total internal reflection surface, and an asymmetric tilted groove filled with light transparent material and covered with the total internal reflection surface.

54. The device of either of claims 29 or 31 wherein the grooves are grooves selected from the group consisting of a hollow symmetric tilted groove filled with light transparent material and covered with the surface (503) and a hollow asymmetric tilted groove filled with light transparent material and covered with the surface (503).

55. The combination of either of claims 30 or 32 wherein the grooves are grooves selected from the group consisting of a hollow symmetric tilted groove filled with light transparent material and covered with the surface (503) and a hollow asymmetric tilted groove filled with light transparent material and covered with the surface (503).

## Patentansprüche

1. Vorrichtung (500) zum Empfangen und zum Richten von Licht auf wenigstens eine vorher festgelegte Position, wobei die Vorrichtung wenigstens einen Empfänger/Wellenrichter zum Richten von Licht auf eine vorher festgelegte Position (513) hat,
wobei der Empfänger/Wellenrichter folgendes aufweist:
eine Total-Innenreflexionsfläche (503), die in der Lage ist, ankommendes Licht (501), das außen auf die total innen reflektierende Oberfläche (503) einfällt, in die Vorrichtung zu übertragen, und das Licht, das auf die Total-Innenreflexionsfläche (503) einfällt, in einem Winkel in wenigstens einer Ebene total innen zu reflektieren, die innerhalb des Bereichs für die Totalinnenreflexion liegt, und
lichtreflektierende Oberflächen (504, 505), wobei die reflektierenden Oberflächen (504, 505) und die Total-Innenreflexionsfläche (503) im Verhältnis zueinander funktionell so angeordnet sind, daß sie ankommendes Licht (501), das durch die Total-Innenreflexionsfläche (503) in die Vorrichtung übertragen wird, auf eine dreidimensionale Weise auf die vorher festgelegte Position reflektieren und richten, dadurch gekennzeichnet, daß der Empfänger/Wellenrichter wenigstens zwei Wellenfallen (804) einschließt, wobei jede Wellenfalle (804) zwei Reflektoroberflächen (504, 505) hat, die gegenseitig so angeordnet sind, daß sie die Wellenfalle (804) bilden, wobei jede Wellenfalle (804) mit einem lichtdurchlässigen Material gefüllt ist, wobei die Wellenfallen (804) derartig im Verhältnis zur Total-Innenreflexionsfläche (503) angeordnet sind, daß die Grundlinie jeder Wellenfalle (804), die durch den Schnittpunkt der Reflektoroberflächen (504, 505) gebildet wird, im Verhältnis zur Total-Innenreflexionsfläche (503) geneigt ist.

2. Kombination, die wenigstens eine Vorrichtung nach Anspruch 1 zusammen mit wenigstens einem Photoelement (514), das eine lichtabsorbierende Oberfläche hat, aufweist, wobei wenigstens ein Teil der lichtabsorbierenden Oberfläche funktionell an einer vorher festgelegten Position angeordnet ist, um das Licht zu absorbieren, das durch den Empfänger/Wellenrichter reflektiert und gerichtet wird.

3. Vorrichtung nach Anspruch 1, bei der die wenigstens zwei Wellenfallen (804) nebeneinander angeordnet sind.

4. Kombination nach Anspruch 2, bei der die wenigstens zwei Wellenfallen (804) nebeneinander angeordnet sind.

5. Vorrichtung nach Anspruch 1 oder Anspruch 3, bei der die wenigstens zwei Wellenfallen (804) aus der Gruppe ausgewählt werden, die aus einer gefüllten, symmetrischen, geneigten Wellenfalle und einer gefüllten, asymmetrischen, geneigten Wellenfalle besteht.

6. Kombination nach Anspruch 2 oder Anspruch 4, bei der die wenigstens zwei Wellenfallen (804) aus der Gruppe ausgewählt werden, die aus einer gefüllten, symmetrischen, geneigten Wellenfalle und einer gefüllten, asymmetrischen, geneigten Wellenfalle besteht.

7. Vorrichtung nach Anspruch 1, bei der die reflektierenden Oberflächen Oberflächen sind, die aus der Gruppe ausgewählt werden, die aus Oberflächen, die mit lichtreflektierendem Material bedeckt sind, und total innen reflektierenden Oberflächen besteht.

8. Kombination nach Anspruch 2, bei der die reflektierenden Oberflächen Oberflächen sind, die aus der Gruppe ausgewählt werden, die aus Oberflächen, die mit lichtreflektierendem Material bedeckt sind, und total innen reflektierenden Oberflächen besteht.

9. Vorrichtung nach einem der Ansprüche 3 oder 5, bei der die Wellenfallen Wellenfallen sind, die aus der Gruppe ausgewählt werden, die aus einer symmetrischen, geneigten Wellenfalle, die mit lichtdurchlässigem Fluid gefüllt und mit der Total-Innenreflexionsfläche bedeckt ist, einer asymmetrischen, geneigten Wellenfalle, die mit lichtdurchlässigem Fluid gefüllt und mit der Total-Innenreflexionsfläche bedeckt ist, einer symmetrischen, geneigten Wellenfalle, die mit lichtdurchlässigem Material gefüllt und mit der Total-Innenreflexionsfläche bedeckt ist, und einer asymmetrischen, geneigten Wellenfalle, die mit lichtdurchlässigem Material gefüllt und mit der Total-Innenreflexionsfläche bedeckt ist, besteht.

10. Kombination nach einem der Ansprüche 4 oder 6, bei der die Wellenfallen Wellenfallen sind, die aus der Gruppe ausgewählt werden, die aus einer symmetrischen, geneigten Wellenfalle, die mit lichtdurchlässigem Fluid gefüllt und mit der Total-Innenreflexionsfläche bedeckt ist, einer asymmetrischen, geneigten Wellenfalle, die mit lichtdurchlässigem Fluid gefüllt und mit der Total-Innenreflexionsfläche bedeckt ist, einer symmetrischen, geneigten Wellenfalle, die mit lichtdurchlässigem Material gefüllt und mit der Total-Innenreflexionsfläche bedeckt ist, und einer asymmetrischen, geneigten Wellenfalle, die mit lichtdurchlässigem Material gefüllt und mit der Total-Innenreflexionsfläche bedeckt ist, besteht.

11. Vorrichtung nach Anspruch 1, die eine Vielzahl von Empfängern/Wellenrichtern aufweist.

12. Vorrichtung nach Anspruch 11, bei der 4 bis 60 Empfänger/Wellenrichter vorhanden sind.

13. Kombination nach Anspruch 2, die eine Vielzahl von Empfängern/Wellenrichtern aufweist.

14. Kombination nach Anspruch 13, bei der 4 bis 60 Empfänger/Wellenrichter vorhanden sind.

15. Kombination nach Anspruch 13, die eine Vielzahl von Photoelementen aufweist.

16. Vorrichtung nach Anspruch 1, bei der die Vorrichtung ein Bauteil ist, das aus der Gruppe ausgewählt wird, die aus einem Ziegelstein, einem Dachziegel oder einem Teil einer Platte besteht.

17. Kombination nach Anspruch 2, bei der die Vorrichtung ein Bauteil ist, das aus der Gruppe ausgewählt wird, die aus einem Ziegelstein, einem Dachziegel oder einem Teil einer Platte besteht.

18. Kombination nach Anspruch 2, bei der die lichtabsorbierende Oberfläche die Unterseite eines Photoelements ist.

19. Kombination nach Anspruch 2, die eine Vielzahl von Empfängern/Wellenrichtern und ein Photoelement umfaßt.

20. Kombination nach Anspruch 2, bei der die Vorrichtung außerdem lichtreflektierende Oberflächen, die funktionell im Verhältnis zur Total-Innenreflexionsfläche und zur lichtabsorbierenden Oberfläche angeordnet sind, und wahlweise zwei lichtreflektierende Oberflächen aufweist, um einfallendes Licht von der Total-Innenreflexionsfläche und wahlweise den zwei lichtreflektierenden Oberflächen direkt auf die lichtabsorbierende Oberfläche zu reflektieren.

21. Kombination nach Anspruch 2, bei der das Photoelement eine Lichtwandlerzelle ist.

22. Kombination nach Anspruch 21, bei der die Lichtwandlerzelle eine Zelle ist, die aus der Gruppe ausgewählt wird, die aus einer pn-Photozelle, einer amorphen Photozelle, einer Schottky-Photozelle, einer photo-elektrochemischen Photozelle, einer MIS-Photozelle, einer im-Photozelle und einer pp-Photozelle besteht.

23. Kombination nach Anspruch 22, bei der die Lichtwandlerzelle eine Zelle ist, die aus der Gruppe ausgewählt wird, die aus einer Solarzelle, einer Wolfram-Lichtwandlerzelle, einer Halogen-Lichtwandlerzelle, einer fluoreszierenden Lichtwandlerzelle, einer Photodioden-Lichtwandlerzelle und einer Laser-Lichtwandlerzelle besteht.

24. Kombination nach Anspruch 23, bei der die Zelle eine pn-Solarzelle ist, die aus Halbleitermaterial hergestellt wird, das aus der Gruppe ausgewählt wird, die aus Si, GaAs, AlGaAs, Ge, CdTe, CuInSe₂, GaP, GaAsP und InP besteht.

25. Vorrichtung nach einem der Ansprüche 1, 3, 5, 7, 9, 11, 12 oder 16, bei der die total reflektierende Oberfläche die Oberseite der Wellenfallen bedeckt, wodurch die Winkel, die durch die reflektierenden Oberflächen zur Total-Innenreflexionsfläche in der Z-Y-Ebene gebildet werden, eine solche Größenordnungen haben, daß normal einfallendes Licht erneut auf die Total-Innenreflexionsfläche bei Winkeln einer solchen Größenordnung auftrifft, daß es an der Total-Innenreflexionsfläche total innen reflektiert wird und gleichzeitig zu einem Ende der geneigten Wellenfalle in der X-Richtung gerichtet wird.

26. Kombination nach einem der Ansprüche 2, 4, 6, 8, 10, 13, 14, 15 oder 18 bis 24, bei der die total reflektierende Oberfläche die Oberseite der Wellenfallen bedeckt, wodurch die Winkel, die durch die reflektierenden Oberflächen zur Total-Innenreflexionsfläche in der Z-Y-Ebene gebildet werden, eine solche Größenordnungen haben, daß normal einfallendes Licht erneut auf die Total-Innenreflexionsfläche bei Winkeln von einer solchen Größenordnung auftrifft, daß es an der Total-Innenreflexionsfläche total innen reflektiert wird und gleichzeitig zu einem Ende der geneigten Wellenfalle in der X-Richtung gerichtet wird.

27. Vorrichtung (500) zum Empfangen und zum Richten von Licht zu wenigstens einer vorher festgelegten Position, wobei die Vorrichtung wenigstens einen Empfänger/Wellenrichter zum Richten von Licht zu einer vorher festgelegten Position (513) hat,
wobei der Empfänger! Wellenrichter folgendes aufweist:
eine Oberfläche (503), die in der Lage ist, ankommendes Licht (501), das außen auf die Oberfläche (503) einfällt, in die Vorrichtung zu übertragen, und
lichtreflektierende Oberflächen (504, 505),
wobei die reflektierenden Oberflächen (504, 505) und die Oberfläche (503) im Verhältnis zueinander funktionell so angeordnet sind, daß eine hohle Wellenfalle (804) gebildet wird, dadurch gekennzeichnet, daß der Empfänger/Wellenrichter wenigstens zwei hohle Wellenfallen (804) einschließt, wobei jede Wellenfalle (804) mit einem lichtdurchlässigen Material gefüllt werden kann, um einen optischen Hohlraum zu bilden, wobei die Wellenfallen (804) derartig im Verhältnis zur Oberfläche (503) angeordnet sind, daß die Grundlinie jeder Wellenfalle (804), die durch den Schnittpunkt der Reflektoroberflächen (504) und (505) gebildet wird, im Verhältnis zu der Oberfläche (503) geneigt ist, und bei der die Oberfläche (503) in der Lage ist, das auf die Oberfläche (503) einfallende Licht in einem Winkel in wenigstens einer Ebene total innen zu reflektieren, die innerhalb des Bereichs für die Totalinnenreflexion liegt, wenn die Wellenfalle (804) mit dem lichtdurchlässigen Material gefüllt ist, wobei die reflektierenden Oberflächen (504, 505) und die Oberfläche (503) außerdem im Verhältnis zueinander und zu der vorher festgelegten Position (513) funktionell so angeordnet sind, daß ankommendes Licht (501), das durch die Oberfläche (503) in die Vorrichtung übertragen wird, auf eine dreidimensionale Weise zu der vorher festgelegten Position (513) übertragen wird.

28. Kombination, die wenigstens eine Vorrichtung nach Anspruch 27 zusammen mit wenigstens einem Photoelement (514), das eine lichtabsorbierende Oberfläche hat, aufweist, wobei wenigstens ein Teil der lichtabsorbierenden Oberfläche funktionell an der vorher festgelegten Position angeordnet ist, um Licht zu absorbieren, das durch den Empfänger/Wellenrichter reflektiert und gerichtet wird.

29. Vorrichtung nach Anspruch 27, bei der die wenigstens zwei Wellenfallen (804) nebeneinander angeordnet sind.

30. Kombination nach Anspruch 28, bei der die wenigstens zwei Wellenfallen (804) nebeneinander angeordnet sind.

31. Vorrichtung nach Anspruch 27 oder Anspruch 29, bei der die wenigstens zwei Wellenfallen (804) aus der Gruppe ausgewählt werden, die aus einer symmetrischen, geneigten Wellenfalle und einer asymmetrischen, geneigten Wellenfalle besteht.

32. Kombination nach Anspruch 28 oder Anspruch 30, bei der die wenigstens zwei Wellenfallen (804) aus der Gruppe ausgewählt werden, die aus einer symmetrischen, geneigten Wellenfalle und einer asymmetrischen, geneigten Wellenfalle besteht.

33. Kombination nach Anspruch 28, bei der die reflektierenden Oberflächen Oberflächen sind, die aus der Gruppe ausgewählt werden, die aus Oberflächen, die mit lichtreflektierendem Material bedeckt sind, und total innen reflektierenden Oberflächen besteht.

34. Vorrichtung nach einem der Ansprüche 29 oder 31, bei der die Wellenfallen Wellenfallen sind, die aus der Gruppe ausgewählt werden, die aus einer hohlen, symmetrischen, geneigten Wellenfalle, die mit lichtdurchlässigem Fluid gefüllt und mit der Oberfläche (503) bedeckt ist, und einer hohlen, asymmetrischen, geneigten Wellenfalle, die mit lichtdurchlässigem Fluid gefüllt und mit der Oberfläche (503) bedeckt ist, besteht.

35. Kombination nach einem der Ansprüche 30 oder 32, bei der die Wellenfallen Wellenfallen sind, die aus der Gruppe ausgewählt werden, die aus einer hohlen, symmetrischen, geneigten Wellenfalle, die mit lichtdurchlässigem Fluid gefüllt und mit der Oberfläche (503) bedeckt ist, und einer hohlen, asymmetrischen, geneigten Wellenfalle, die mit lichtdurchlässigem Fluid gefüllt und mit der Oberfläche (503) bedeckt ist, besteht.

36. Vorrichtung nach Anspruch 27, die eine Vielzahl von Empfängern/Wellenrichtern aufweist.

37. Vorrichtung nach Anspruch 36, bei der 4 bis 60 Empfänger/Wellenrichter vorhanden sind.

38. Kombination nach Anspruch 28, die eine Vielzahl von Empfängern/Wellenrichtem aufweist.

39. Kombination nach Anspruch 38, bei der 4 bis 60 Empfänger/Wellenrichter vorhanden sind.

40. Kombination nach Anspruch 38, die eine Vielzahl von Photoelementen aufweist.

41. Vorrichtung nach Anspruch 27, bei der die Vorrichtung ein Bauteil ist, das aus der Gruppe ausgewählt wird, die aus einem Ziegelstein, einem Dachziegel oder einem Teil einer Platte besteht.

42. Kombination nach Anspruch 28, bei der die Vorrichtung ein Bauteil ist, das aus der Gruppe ausgewählt wird, die aus einem Ziegelstein, einem Dachziegel oder einem Teil einer Platte besteht.

43. Kombination nach Anspruch 28, bei der die lichtabsorbierende Oberfläche die Unterseite eines Photoelements ist.

44. Kombination nach Anspruch 28, die eine Vielzahl von Empfängern/Wellenrichtern und ein Photoelement umfaßt.

45. Kombination nach Anspruch 28, bei der die Vorrichtung außerdem lichtreflektierende Oberflächen, die funktionell im Verhältnis zur Total-Innenreflexionsfläche und zur lichtabsorbierenden Oberfläche angeordnet sind, und wahlweise zwei lichtreflektierende Oberflächen aufweist, um einfallendes Licht von der Total-Innenreflexionsfläche und wahlweise den zwei lichtreflektierenden Oberflächen direkt auf die lichtabsorbierende Oberfläche zu reflektieren.

46. Kombination nach Anspruch 28, bei der das Photoelement eine Lichtwandlerzelle ist.

47. Kombination nach Anspruch 46, bei der die Lichtwandlerzelle eine Zelle ist, die aus der Gruppe ausgewählt wird, die aus einer pn-Photozelle, einer amorphen Photozelle, einer Schottky-Photozelle, einer photo-elektrochemischen Photozelle, einer MIS-Photozelle, einer nn-Photozelle und einer pp-Photozelle besteht.

48. Kombination nach Anspruch 47, bei der die Lichtwandlerzelle eine Zelle ist, die aus der Gruppe ausgewählt wird, die aus einer Solarzelle, einer Wolfram-Lichtwandlerzelle, einer Halogen-Lichtwandlerzelle, einer fluoreszierenden Lichtwandlerzelle, einer Photodioden-Lichtwandlerzelle und einer Laser-Lichtwandlerzelle besteht.

49. Kombination nach Anspruch 48, bei der die Zelle eine pn-Solarzelle ist, die aus Halbleitermaterial hergestellt wird, das aus der Gruppe ausgewählt wird, die aus Si, GaAs, AlGaAs, Ge, CdTe, CuInSe₂, GaP, GaAsP und InP besteht.

50. Vorrichtung nach einem der Ansprüche 7, 27, 29, 31, 34, 36, 37 oder 41, bei der die total reflektierende Oberfläche an der Oberseite der Wellenfallen angeordnet ist, wodurch die Winkel, die durch die reflektierenden Oberflächen zur Total-Innenreflexionsfläche in der Z-Y-Ebene gebildet werden, eine solche Größenordnung haben, daß normal einfallendes Licht erneut auf die Total-Innenreflexionsfläche bei Winkeln von einer solchen Größenordnung auftrifft, daß es an der Total-Innenreflexionsfläche total innen reflektiert wird und gleichzeitig zu einem Ende der geneigten Wellenfalle in der X-Richtung gerichtet wird.

51. Kombination nach einem der Ansprüche 28, 30, 32, 33, 35, 38, 39, 40 oder 42 bis 49, bei der die total reflektierende Oberfläche an der Oberseite der Wellenfallen angeordnet ist, wodurch die Winkel, die durch die reflektierenden Oberflächen zur Total-Innenreflexionsfläche in der Z-Y-Ebene gebildet werden, eine solche Größenordnung haben, daß normal einfallendes Licht erneut auf die Total-Innenreflexionsfläche bei Winkeln von einer solchen Größenordnung auftrifft, daß es an der Total-Innenreflexionsfläche total innen reflektiert wird und gleichzeitig zu einem Ende der geneigten Wellenfalle in der X-Richtung gerichtet wird.

52. Vorrichtung nach einem der Ansprüche 3 oder 5, bei der die Wellenfallen Wellenfallen sind, die aus der Gruppe ausgewählt werden, die aus einer symmetrischen, geneigten Wellenfalle, die mit lichtdurchlässigem Material gefüllt und mit der Total-Innenreflexionsfläche bedeckt ist, und einer asymmetrischen, geneigten Wellenfalle, die mit lichtdurchlässigem Material gefüllt und mit der Total-Innenreflexionsfläche bedeckt ist, besteht.

53. Kombination nach einem der Ansprüche 4 oder 6, bei der die Wellenfallen Wellenfallen sind, die aus der Gruppe ausgewählt werden, die aus einer symmetrischen, geneigten Wellenfalle, die mit lichtdurchlässigem Material gefüllt und mit der Total-Innenreflexionsfläche bedeckt ist, und einer asymmetrischen, geneigten Wellenfalle, die mit lichtdurchlässigem Material gefüllt und mit der Total-Innenreflexionsfläche bedeckt ist, besteht.

54. Vorrichtung nach einem der Ansprüche 29 oder 31, bei der die Wellenfallen Wellenfallen sind, die aus der Gruppe ausgewählt werden, die aus einer hohlen, symmetrischen, geneigten Wellenfalle, die mit lichtdurchlässigem Material gefüllt und mit der Oberfläche (503) bedeckt ist, und einer hohlen, asymmetrischen, geneigten Wellenfalle, die mit lichtdurchlässigem Material gefüllt und mit der Oberfläche (503) bedeckt ist, besteht.

55. Kombination nach einem der Ansprüche 30 oder 32, bei der die Wellenfallen Wellenfallen sind, die aus der Gruppe ausgewählt werden, die aus einer hohlen, symmetrischen, geneigten Wellenfalle, die mit lichtdurchlässigem Material gefüllt und mit der Oberfläche (503) bedeckt ist, und einer hohlen, asymmetrischen, geneigten Wellenfalle, die mit lichtdurchlässigem Material gefüllt und mit der Oberfläche (503) bedeckt ist, besteht.

## Revendications

1. Dispositif (500) destiné à recevoir et à diriger la lumière vers au moins un emplacement prédéterminé, le dispositif comportant au moins un récepteur/guide pour diriger la lumière vers un emplacement prédéterminé (513);
le récepteur/guide comprenant:
une surface de réflexion interne totale (503) capable de transmettre la lumière entrante (501), incidente sur l'extérieur de ladite surface de réflexion interne totale (503) dans le dispositif et d'assurer une réflexion interne totale de la lumière incidente sur la surface de réflexion interne totale (503) à un angle dans au moins un plan agencé dans l'intervalle de la réflexion interne totale; et
des surfaces de réflexion de la lumière (504, 505), les surfaces de réflexion (504, 505) et la surface de réflexion interne totale (503) étant en service agencées les unes par rapport aux autres de sorte à réfléchir et à diriger la lumière entrante (501) transmise par la surface de réflexion interne totale (503) dans le dispositif, de manière tridimensionnelle vers l'emplacement prédéterminé, caractérisé en ce que le récepteur/guide englobe au moins deux rainures (804), chaque rainure (804) comportant deux surfaces de réflexion (504, 505) agencées l'une par rapport à l'autre de sorte à former la rainure (804), chaque rainure (804) étant remplie d'un matériau transparent à la lumière, les rainures (804) étant agencées par rapport à la surface de réflexion interne totale (503) de sorte que la ligne de base de chaque rainure (804) définie par l'intersection des surfaces de réflexion (504, 505) est inclinée par rapport à la surface de réflexion interne totale (503).

2. Combinaison comprenant au moins un dispositif selon la revendication 1, et au moins un dispositif photo-électrique (514) comportant une surface d'absorption de la lumière, au moins une partie de la surface d'absorption de la lumière étant en service agencée au niveau de l'emplacement déterminé pour absorber la lumière réfléchie et dirigée par le récepteur/guide.

3. Dispositif selon la revendication 1, dans lequel au moins deux rainures (804) sont agencées côte à côte.

4. Combinaison selon la revendication 2, dans laquelle au moins deux rainures (804) sont agencées côte à côte.

5. Dispositif selon les revendications 1 ou 3, dans lequel lesdites au moins deux rainures (804) sont sélectionnées dans le groupe constitué d'une rainure inclinée symétrique remplie et d'une rainure inclinée asymétrique remplie.

6. Combinaison selon les revendications 2 ou 4, dans laquelle lesdites au moins deux rainures (804) sont sélectionnées dans le groupe constitué d'une rainure inclinée symétrique remplie et d'une rainure inclinée asymétrique remplie.

7. Dispositif selon la revendication 1, dans lequel les surfaces de réflexion sont des surfaces sélectionnées dans le groupe constitué de surfaces revêtues d'un matériau réfléchissant la lumière et de surfaces à réflexion interne totale.

8. Combinaison selon la revendication 2, dans laquelle les surfaces de réflexion sont des surfaces sélectionnées dans le groupe constitué de surfaces revêtues d'un matériau réfléchissant la lumière et de surfaces à réflexion interne totale.

9. Dispositif selon l'une des revendications 3 ou 5, dans lequel les rainures sont des rainures sélectionnées dans le groupe constitué d'une rainure inclinée symétrique remplie de fluide transparent à la lumière et recouverte par la surface de réflexion interne totale, d'une rainure inclinée asymétrique remplie de fluide transparent à la lumière et recouverte de la surface de réflexion interne totale, d'une rainure inclinée symétrique remplie de matériau transparent à la lumière et recouverte de la surface de réflexion interne totale et d'une rainure inclinée asymétrique remplie de matériau transparent à la lumière et recouverte de la surface de réflexion interne totale.

10. Combinaison selon les revendications 4 ou 6, dans laquelle les rainures sont des rainures sélectionnées dans le groupe constitué d'une rainure inclinée symétrique remplie de fluide transparent à la lumière et recouverte par la surface de réflexion interne totale, d'une rainure inclinée asymétrique remplie de fluide transparent à la lumière et recouverte de la surface de réflexion interne totale, d'une rainure inclinée symétrique remplie de matériau transparent à la lumière et recouverte de la surface de réflexion interne totale et d'une rainure inclinée asymétrique remplie de matériau transparent à la lumière et recouverte de la surface de réflexion interne totale.

11. Dispositif selon la revendication 1 comprenant plusieurs récepteurs/guides.

12. Dispositif selon la revendication 11, comportant 4 à 60 récepteurs/guides

13. Combinaison selon la revendication 2 comprenant plusieurs récepteurs/guides.

14. Combinaison selon la revendication 13, comportant 4 à 60 récepteurs/guides

15. Combinaison selon la revendication 13, comprenant plusieurs dispositifs photoélectriques.

16. Dispositif selon la revendication 1, dans lequel le dispositif est un composant structural sélectionné dans le groupe constitué d'une brique, d'une tuile ou d'une partie d'un panneau.

17. Combinaison selon la revendication 2, dans laquelle le dispositif est un composant structural sélectionné dans le groupe constitué d'une brique, d'une tuile ou d'une partie d'un panneau.

18. Combinaison selon la revendication 2, dans laquelle la surface d'absorption de la lumière est constituée par le côté inférieur d'un dispositif photo-électrique.

19. Combinaison selon la revendication 2, comprenant plusieurs récepteurs/guides et un dispositif photo-électrique.

20. Combinaison selon la revendication 2, dans laquelle le dispositif comprend en outre des surfaces de réflexion de la lumière agencées en service par rapport à la surface de réflexion interne totale et à la surface d'absorption de la lumière, et optionnellement par rapport à deux surfaces de réflexion de la lumière, de sorte à réfléchir directement la lumière incidente à partir de la surface de réflexion interne totale, et optionnellement à partir de deux surfaces de réflexion de la lumière, vers la surface d'absorption de la lumière.

21. Combinaison selon la revendication 2, dans laquelle le dispositif photo-électrique est une cellule de conversion de la lumière.

22. Combinaison selon la revendication 21, dans laquelle la cellule de conversion de la lumière est une cellule sélectionnée dans le groupe constituée d'une cellule photo-électrique p-n, d'une cellule photo-électrique amorphe, d'une cellule photo-électrique de Schottky, d'une cellule photo-électrochimique, d'une cellule photo-électrique MIS, d'une cellule photo-électrique n-n et d'une cellule photo-électrique p-p.

23. Combinaison selon la revendication 22, dans laquelle la cellule de conversion de la lumière est une cellule sélectionnée dans le groupe constitué d'une cellule solaire, d'une cellule de conversion de la lumière au tungstène, d'une cellule de conversion de la lumière à halogène, d'une cellule de conversion de la lumière fluorescente, d'une cellule de conversion de la lumière à photodiode et d'une cellule de conversion de la lumière à laser.

24. Combinaison selon la revendication 23, dans laquelle la cellule est une cellule solaire p-n fabriquée à partir de matériau semi-conducteur sélectionné dans le groupe constitué de Si, GaAs, AlGaAs, Ge, CdTe, CuInSe₂, GaP, GaAsP et InP.

25. Dispositif selon l'une quelconque des revendications 1, 3, 5, 7, 9, 11, 12 ou 16, dans lequel la surface de réflexion totale recouvre le sommet des rainures, les valeurs des angles formés par les surfaces de réflexion par rapport à la surface de réflexion interne totale dans le plan Z-Y étant telles que la lumière à incidence normale heurtera de nouveau la surface de réflexion interne totale à des angles ayant des valeurs telles à entraîner leur réflexion interne totale au niveau de la surface de réflexion interne totale et leur direction simultanée vers une extrémité de la rainure inclinée dans la direction X.

26. Combinaison l'une quelconque des revendications 2, 4, 6, 8, 10, 13, 14, 15 ou 18 à 24, dans laquelle la surface de réflexion totale recouvre le sommet des rainures, les valeurs des angles formés par les surfaces de réflexion par rapport à la surface de réflexion interne totale dans le plan Z-Y étant tels que la lumière à incidence normale heurtera de nouveau la surface de réflexion interne totale à des angles ayant des valeurs telles à entraîner leur réflexion interne totale au niveau de la surface de réflexion interne totale et leur direction simultanée vers une extrémité de la rainure inclinée dans la direction X.

27. Dispositif (500) destiné à recevoir et à diriger la lumière vers au moins un emplacement prédéterminé, le dispositif comportant au moins un récepteur/guide pour diriger la lumière vers un emplacement prédéterminé (513),
le récepteur/guide comprenant:
une surface (503) capable de transmettre la lumière entrante (501) incidente sur l'extérieur de ladite surface (503) dans le dispositif; et
des surfaces de réflexion de la lumière (504, 505),
le surfaces de réflexion (504, 505) et la surface (503) étant agencées en service les unes par rapport aux autres de sorte à former une rainure creuse (804), caractérisé en ce que le récepteur/guide englobe au moins deux rainures creuses (804), chaque rainure (804) pouvant être remplie d'un matériau transparent à la lumière pour former une cavité optique, les rainures (804) étant agencées par rapport à la surface (503) de sorte que la ligne de base de chaque rainure (804) définie par l'intersection des surfaces de réflexion (504) et (505) est inclinée par rapport à la surface (503), ladite surface (503) étant capable d'assurer une réflexion interne totale de la lumière incidente sur ladite surface (503) à un angle dans au moins un plan, situé dans l'intervalle de la réflexion interne totale lorsque ladite rainure (804) est remplie dudit matériau transparent à la lumière, lesdites surfaces de réflexion (504, 505) et ladite surface (503) étant en outre agencées en service les unes par rapport aux autres et par rapport à l'endroit prédéterminé (513) de sorte à diriger la lumière entrante (501) transmise par la surface (503) dans le dispositif de manière tridimensionnelle vers l'emplacement prédéterminé (513).

28. Combinaison comprenant au moins un dispositif selon la revendication 27 et un dispositif photo-électrique (514) comportant une surface d'absorption de la lumière, au moins une partie de la surface d'absorption de la lumière étant agencée en service au niveau de l'emplacement prédéterminé pour absorber la lumière réfléchie et dirigée par le récepteur/guide.

29. Dispositif selon la revendication 27, dans lequel au moins deux rainures (804) sont agencées côte à côte.

30. Combinaison selon la revendicaiton 28, dans laquelle lesdites au moins deux rainures (804) sont agencées côte à côte.

31. Dispositif selon les revendications 27 ou 29, dans lequel lesdites au moins deux rainures (804) sont sélectionnées dans le groupe constitué d'une rainure inclinée symétrique et d'une rainure inclinée asymétrique.

32. Combinaison selon les revendications 28 ou 30, dans laquelle lesdites au moins deux rainures (804) sont sélectionnées dans le groupe constitué d'une rainure inclinée symétrique et d'une rainure inclinée asymétrique.

33. Combinaison selon la revendication 28, dans laquelle les surfaces de réflexion sont des surfaces sélectionnées dans le groupe constitué de surfaces revêtues d'un matériau réfléchissant la lumière et de surfaces à réflexion interne totale.

34. Dispositif selon l'une des revendications 29 ou 31, dans lequel les rainures sont des rainures sélectionnées dans le groupe constitué d'une rainure inclinée symétrique creuse remplie de fluide transparent à la lumière et recouverte par la surface (503) et d'une rainure inclinée asymétrique creuse remplie de fluide transparent à la lumière et recouverte de la surface (503).

35. Combinaison selon l'une des revendications 30 ou 32, dans laquelle les rainures sont des rainures sélectionnées dans le groupe constitué d'une rainure inclinée symétrique creuse remplie de fluide transparent à la lumière et recouverte par la surface (503) et d'une rainure inclinée asymétrique creuse remplie de fluide transparent à la lumière et recouverte de la surface (503).

36. Dispositif selon la revendication 27 comprenant plusieurs récepteurs/guides.

37. Dispositif selon la revendication 36, comportant 4 à 60 récepteurs/guides

38. Combinaison selon la revendication 28, comprenant plusieurs récepteurs/guides.

39. Combinaison selon la revendication 38, comportant 4 à 60 récepteurs/guides

40. Combinaison selon la revendication 38, comprenant plusieurs dispositifs photo-électriques.

41. Dispositif selon la revendication 27, dans lequel le dispositif est un composant structural sélectionné dans le groupe constitué d'une brique, d'une tuile ou d'une partie d'un panneau.

42. Combinaison selon la revendication 28, dans laquelle le dispositif est un composant structural sélectionné dans le groupe constitué d'une brique, d'une tuile ou d'une partie d'un panneau.

43. Combinaison selon la revendication 28, dans laquelle la surface d'absorption de la lumière est constituée par le côté inférieur d'un dispositif photo-électrique.

44. Combinaison selon la revendication 28, comprenant plusieurs récepteurs/guides et un dispositif photo-électrique.

45. Combinaison selon la revendication 28, dans laquelle le dispositif comprend en outre des surfaces de réflexion de la lumière agencées en service par rapport à la surface de réflexion interne totale et à la surface d'absorption de la lumière, et optionnellement par rapport à deux surfaces de réflexion de la lumière, de sorte à réfléchir directement la lumière incidente à partir de la surface de réflexion interne totale, et optionnellement à partir de deux surfaces de réflexion de la lumière vers la surface d'absorption de la lumière.

46. Combinaison selon la revendication 28, dans laquelle le dispositif photo-électrique est une cellule de conversion de la lumière.

47. Combinaison selon la revendication 46, dans laquelle la cellule de conversion de la lumière est une cellule sélectionnée dans le groupe constituée d'une cellule photo-électrique p-n, d'une cellule photo-électrique amorphe, d'une cellule photo-électrique de Schottky, d'une cellule photo-électrochimique, d'une cellule photo-électrique MIS, d'une cellule photo-électrique n-n et d'une cellule photo-électrique p-p.

48. Combinaison selon la revendication 47, dans laquelle la cellule de conversion de la lumière est une cellule sélectionnée dans le groupe constitué d'une cellule solaire, d'une cellule de conversion de la lumière au tungstène, d'une cellule de conversion de la lumière à halogène, d'une cellule de conversion de la lumière fluorescente, d'une cellule de conversion de la lumière à photodiode et d'une cellule de conversion de la lumière à laser.

49. Combinaison selon la revendication 48, dans laquelle la cellule est une cellule solaire p-n fabriquée à partir de matériau semi-conducteur sélectionné dans le groupe constitué de Si, GaAs, AlGaAs, Ge, CdTe, CuInSe₂, GaP, GaAsP et InP.

50. Dispositif selon l'une quelconque des revendications 7, 27, 29, 31, 34, 36, 37 ou 41, dans laquelle la surface de réflexion totale est agencée au niveau du sommet des rainures, les valeurs des angles formés par les surfaces de réflexion par rapport à la surface de réflexion interne totale dans le plan Z-Y étant tels que la lumière à incidence normale heurtera de nouveau la surface de réflexion interne totale à des angles ayant des valeurs telles à entraîner leur réflexion interne totale au niveau de la surface de réflexion interne totale et leur direction simultanée vers une extrémité de la rainure inclinée dans la direction X.

51. Combinaison selon l'une quelconque des revendications 28, 30, 32, 33, 35, 38, 39, 40 ou 42 à 49, dans laquelle la surface de réflexion totale est agencée au niveau du sommet des rainures, les valeurs des angles formés par les surfaces de réflexion par rapport à la surface de réflexion interne totale dans le plan Z-Y étant telles que la lumière à incidence normale heurtera de nouveau la surface de réflexion interne totale à des angles ayant des valeurs telles à entraîner leur réflexion interne totale au niveau de la surface de réflexion interne totale et leur direction simultanée vers une extrémité de la rainure inclinée dans la direction X.

52. Dispositif selon l'une des revendications 3 ou 5, dans lequel les rainures sont des rainures sélectionnées dans le groupe constitué d'une rainure inclinée symétrique remplie de matériau transparent à la lumière et recouverte de la surface de réflexion interne totale et d'une rainure inclinée asymétrique remplie de matériau transparent à la lumière et recouverte de la surface de réflexion interne totale.

53. Combinaison selon l'une des revendications 4 ou 6, dans laquelle les rainures sont des rainures sélectionnées dans le groupe constitué d'une rainure inclinée symétrique remplie de matériau transparent à la lumière et recouverte de la surface de réflexion interne totale et d'une rainure inclinée asymétrique remplie de matériau transparent à la lumière et recouverte de la surface de réflexion interne totale.

54. Dispositif selon l'une des revendications 29 ou 31, dans lequel les rainures sont des rainures sélectionnées dans le groupe constitué d'une rainure inclinée symétrique creuse remplie de matériau transparent à la lumière et recouverte de la surface (503) et d'une rainure inclinée asymétrique creuse remplie de matériau transparent à la lumière et recouverte de la surface (503).

55. Combinaison selon l'une des revendications 30 ou 32, dans laquelle les rainures sont des rainures sélectionnées dans le groupe constitué d'une rainure inclinée symétrique creuse remplie de matériau transparent à la lumière et recouverte de la surface (503) et d'une rainure inclinée asymétrique creuse remplie de matériau transparent à la lumière et recouverte de la surface (503).
